# EUROPEAN PATENT SPECIFICATION

(11) **EP 2 903 404 B1**
(45) Date of publication and mention of the grant of the patent: **23.05.2018**
(21) Application number: 12885826.3
(22) Date of filing: 27.09.2012
(51) Int. Cl.: H05K 13/02

(54) **COMPONENT SUPPLY DEVICE**
KOMPONENTENZULIEFERUNGSANLAGE
DISPOSITIF D'ALIMENTATION EN COMPOSANTS

(43) Date of publication of application: 05.08.2015
(73) Proprietor: Fuji Machine Mfg. Co., Ltd., Chiryu-shi Aichi 472-8686 (JP)
(72) Inventor: KAKO, Tetsuya, Chiryu-shi Aichi 472-8686 (JP); NAKAI, Kenji, Chiryu-shi Aichi 472-8686 (JP); SHIOYA, Satoshi, Chiryu-shi Aichi 472-8686 (JP)
(74) Representative: Grünecker Patent- und Rechtsanwälte PartG mbB
(86) International application number: PCT/JP2012/074850
(87) International publication number: WO 2014/049767

(56) References cited:
- JP-A- H0 851 289
- JP-A- 2000 294 987
- JP-A- 2001 274 592
- JP-A- 2004 047 858
- JP-A- 2005 032 846
- JP-A- 2006 111 445
- US-A- 4 651 863

## Description

### Technical Field

The present invention relates to a component supply device that supplies electronic components to a chip mounter (which is called a surface mounter or an electronic component assembly apparatus) mounting an electronic component on a circuit substrate.

### Background Art

JP-A-2006-11445 discloses a component supply device in the related art. The component supply device includes holders, each of which holds at least one electronic component, a plurality of receiving sections, each of which can receive the holder, and a transfer mechanism that transfers the holder received in the receiving section to a chip mounter. JP-A-2004-047858 discloses a technique to enable a parts feeder to be loaded in a feeder mounting part properly. Connectors which are connected by loading a parts feeder in a feeder loading part are provided to a feeder plate and the parts feeder. A mounter body is provided with a feeder bank for feeding identification data for every parts feeder to the parts feeder side via connectors. The parts feeder is provided with a display means (a control unit and a display unit) for identifying the feeder plate at a connected side based on the identification data and displays the identification result. US 4,651,863 A discloses a system for machine assembly of component kits for electronic printed circuit boards. Components for assembling the kits are stored in a plurality of standardized machine recoverable trays, more specifically a multi-level carousel. An elevator transports trays between storage and an automated work station where components are removed to construct the component kits

### Summary of Invention

### Technical Problem

When a worker supplies electronic components in this kind of component supply device, the electronic components are set in a holder and the holder is set in a designated receiving section. In this case, if the worker mistakes the receiving section in which the holder is to be set, the component supply device supplies wrong electronic components to a chip mounter. In order to avoid this problem, the above-mentioned component supply device in the related art is adapted to read a bar code attached to a holder when transferring the holder to a chip mounter. Accordingly, verification of whether or not the holder transferred to the chip mounter is a correct holder (that is, electronic components are correct electronic components) is performed.

In the component supply device in the related art, verification of the holder is performed when being transferred to a chip mounter. Even though a worker mistakes a receiving section in which a holder is to be set, this mistake cannot be detected at this stage in this structure. For this reason, when a worker mistakes a receiving section in which a holder is to be set, there is a problem in that the delay of a production schedule occurs due to the stoppage of the operation of the chip mounter.

In consideration of the above-mentioned problem, an object of the invention disclosed in this specification is to prevent a human error in which a worker sets a holder in a wrong receiving section.

### Solution to Problem

The object is achieved with component supply devices according to independent claims 1, 3, 5, 7, 9 and 11. Additional advantages are attained with the preferred embodiments set out in the dependent claims. This specification discloses a component supply device that supplies electronic components to a chip mounter. This component supply device includes holders, each of which holds at least one electronic component, a plurality of receiving sections, each of which can receive the holder, a plurality of first identifiers that are assigned to the plurality of receiving sections, respectively, and an information mechanism that informs a worker of the first identifier assigned to the receiving section in which the holder has been set when the worker sets the holder in the receiving section.

In this component supply device, these identifiers (for example, bar codes), which are assigned to the respective receiving sections, can be read by the reading unit (for example, a bar code reader). When a worker sets a holder in a receiving section, the worker can read an identifier, which is assigned to the receiving section, by the reading unit. Accordingly, whether or not a receiving section in which a worker actually has set a holder is a designated receiving section can be verified by a computer or the like. Therefore, it is possible to avoid a human error.

Particularly, this component supply device is adapted to inform a worker of the identifier assigned to the receiving section when the worker sets the holder in the receiving section. Accordingly, a human error in which a worker mistakenly reads an identifier assigned to another receiving section is prevented.

In an embodiment, it is preferable that the information mechanism includes a plurality of movable members provided on the plurality of receiving sections, respectively. In this case, it is preferable that each of the plurality of first identifiers is mounted on the movable member provided on one corresponding receiving section. When a worker sets the holder in the receiving section, it is preferable that a movable member provided on the receiving section is moved to a second position from a first position while interlocking with an operation of the holder. According to this structure, when a worker sets the holder in the receiving section, one movable member is moved to the second position. The identifier of the receiving section in which a worker has set the holder is mounted on the movable member that has been moved to the second position. The worker can know that the identifier mounted on the movable member moved to the second position is the identifier of the receiving section in which the holder has been actually set.

In the above-mentioned embodiment, it is preferable that the first identifier is not readable when the movable member is present at the first position and the first identifier is readable when the movable member is present at the second position. According to this structure, when a worker reads the identifier mounted on the movable member, it is possible to reliably prevent a human error in which the worker mistakenly reads an identifier mounted on another movable member.

In an embodiment, it is preferable that the information mechanism includes indicating members provided on the holders and including window portions. In this case, when a worker sets the holder in the receiving section, it is preferable that the indicating member can be disposed so that the window portion overlaps the first identifier assigned to the receiving section in which the holder is set. According to this structure, a worker can know that the identifier seen from the window portion of the indicating member is the identifier of the receiving section in which the holder has been actually set.

In the above-mentioned embodiment, when the indicating member is disposed so that the window portion overlaps one first identifier, it is preferable that the indicating member covers and hides at least a part of the other first identifiers adjacent to the one first identifier. According to this structure, when a worker reads an identifier seen from the window portion, it is possible to prevent a mistake in which the worker mistakenly reads an adjacent identifier.

In an embodiment, when a worker sets the holder in the receiving section, it is preferable that the information mechanism allows the first identifier assigned to the receiving section, in which the holder is set, to be readable and does not allow the other first identifiers to be readable. According to this structure, a worker can know that the identifier allowed to be readable is the identifier of the receiving section in which the holder has been actually set.

In an embodiment, it is preferable that the first identifier is a bar code or a two-dimensional code. A bar code or a two-dimensional code can record information that is sufficient to identify the plurality of receiving sections, and facilitates the creation of the information.

This specification discloses another component supply device. This component supply device includes holders, each of which holds at least one electronic component, a plurality of receiving sections, each of which can receive the holder, a plurality of first identifiers that are assigned to the plurality of receiving sections, respectively, and a reading unit that is mounted on the holder and reads the first identifier assigned to the receiving section when a worker sets the holder in the receiving section. According to this structure, when setting the holder in the receiving section, a worker can mount the reading unit on the holder. Further, when a worker sets a holder in a receiving section, the first identifier assigned to the receiving section is automatically read. Accordingly, a human error in which a worker mistakenly reads an identifier assigned to another receiving section is prevented.

When the reading unit is mounted on the holder, it is preferable that the reading unit further reads a second identifier attached to the holder. According to this structure, it is possible to verify whether or not the combination of the holder and the receiving section in which the holder has been set is correct.

This specification discloses another component supply device. This component supply device includes holders, each of which holds at least one electronic component and to which second identifiers are attached, a plurality of receiving sections, each of which can receive the holder, a plurality of first identifiers that are assigned to the plurality of receiving sections, respectively, a reading unit that reads the first identifiers and the second identifiers, a first support mechanism that supports the reading unit so that the reading unit is movable or rotatable in a first direction, a second support mechanism that supports the reading unit so that the reading unit is movable or rotatable in a second direction, and a lock mechanism that allows/prevents the movement or rotation of the reading unit in the first direction that is caused by the first support mechanism. When the reading unit is moved or rotated from a position, at which the reading unit reads the second identifier of the holder set in the receiving section, in the second direction, the reading unit reaches a position at which the reading unit reads the first identifier assigned to the receiving section.

When a worker sets the holder in the receiving section in this component supply device, the reading unit is moved or rotated in the first or second direction and reads the second identifier attached to the holder. After that, when the worker prevents the movement or rotation of the reading unit in the first direction by the lock mechanism and moves or rotates the reading unit in the second direction, it is possible to read one first identifier. This first identifier is the first identifier assigned to the receiving section in which the worker has set the holder. The worker can avoid a mistake in which the worker mistakenly reads an identifier assigned to the other receiving section, by following the above-mentioned predetermined procedure as described above.

It is preferable that each of the plurality of receiving sections and the plurality of identifiers are arranged in the first direction. In this case, the first direction can be, for example, a vertical direction.

This specification discloses another component supply device. This component supply device includes holders, each of which holds at least one electronic component, a plurality of receiving sections, each of which can receive the holder, a reading unit that reads a second identifier attached to the holder set in the receiving section, and a position detection unit that detects a position of the reading unit when the reading unit reads the second identifier. According to this structure, the receiving section in which a worker has set the holder can be specified on the basis of the detected position of the reading unit.

It is preferable that the reading unit is supported so as to be movable at least in a direction where the plurality of receiving sections are arranged. Further, it is preferable that the position detection unit detects the position of the reading unit at least in the direction where the plurality of receiving sections are arranged. According to this structure, it is possible to provide the component supply device with a relatively simple structure.

This specification discloses another component supply device. This component supply device includes holders, each of which holds at least one electronic component, a plurality of receiving sections, each of which can receive the holder, and a plurality of jigs which are prepared on the plurality of receiving sections, respectively, and one of the jigs can be selectively mounted on the holder. The plurality of jigs have shapes different from one another. Each of the plurality of receiving sections has a shape that allows the receiving section to receive the holder on which one corresponding jig is mounted and does not allow the receiving section to receive the holders on which the other jigs are mounted.

When a worker sets the holder in the receiving section in this component supply device, the jig corresponding to the receiving section in which the holder is to be set can be mounted on the holder in advance. As a result, since the holder can be set only in a correct receiving section, a human error in which a worker sets the holder in a wrong receiving section is prevented.

### Brief Description of Drawings

[Fig. 1] Fig. 1 schematically shows a chip mounter and a component supply device.
[Fig. 2] Fig. 2 shows a tray pallet that is an example of a pallet.
[Fig. 3] Fig. 3 shows a wafer pallet that is an example of a pallet.
[Fig. 4] Fig. 4 is a front view of a component supply device of a first embodiment.
[Fig. 5] Fig. 5 shows a plurality of movable members.
[Fig. 6] Fig. 6 shows a movable member that is present at a first position and a pallet that is to be set in a receiving section.
[Fig. 7] Fig. 7 shows a movable member that is moved to a second position while interlocking with a pallet to be set in a receiving section.
[Fig. 8] Fig. 8 shows a movable member that informs a worker of an identifier to be read when the worker sets a pallet in a receiving section.
[Fig. 9] Fig. 9 is a front view of a component supply device of a second embodiment.
[Fig. 10] Fig. 10 shows an indicating member that is mounted on a tray pallet.
[Fig. 11] Fig. 11 is an indicating member that is mounted on a wafer pallet.
[Fig. 12] Fig. 12 shows an indicating member that informs a worker of an identifier to be read when the worker sets a pallet in a receiving section.
[Fig. 13] Fig. 13 is a front view of a component supply device of a third embodiment.
[Fig. 14] Fig. 14 is a perspective view of a component supply device of a fourth embodiment.
[Fig. 15] Fig. 15 is a perspective view of a component supply device of a fifth embodiment.
[Fig. 16] Fig. 16 shows a reading unit, which is rotated in a horizontal direction and reads the bar code of a receiving section, of the component supply device of the fifth embodiment.

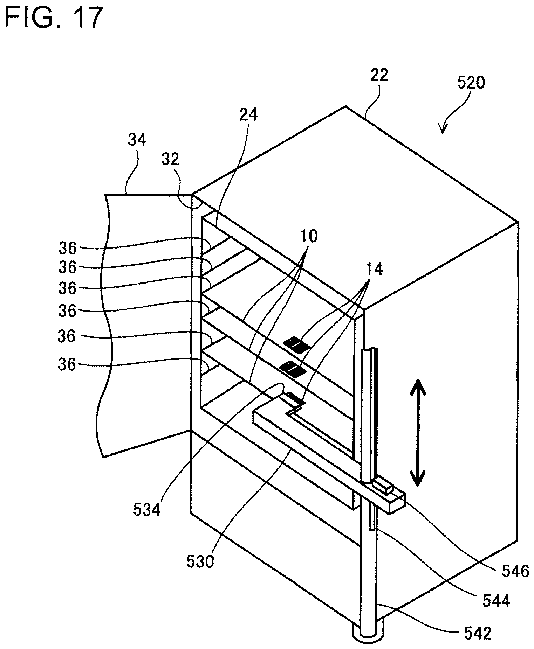

[Fig. 17] Fig. 17 is a perspective view of a component supply device of an example which is not claimed but is useful for understanding the present invention.
[Fig. 18] Fig. 18 is a front view of a component supply device of a sixth embodiment.
[Fig. 19] Fig. 19 shows a key jig that is mounted on a pallet in the sixth embodiment.
[Fig. 20] Fig. 20 shows an aspect in which the key jig mounted on the pallet is fitted to a gate jig provided on a corresponding receiving section in the sixth embodiment.

### Description of Embodiments

### First embodiment

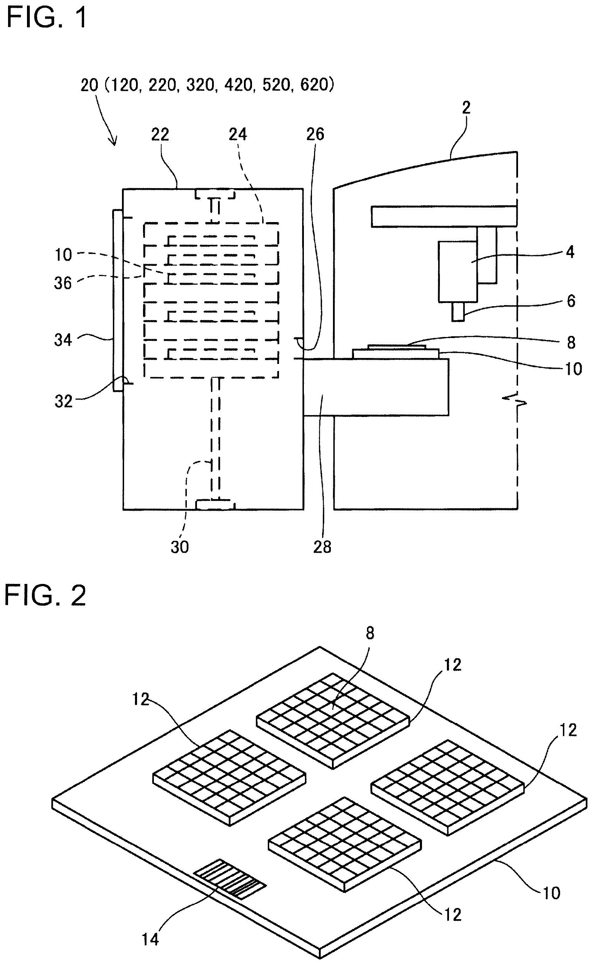

A component supply device 20 of a first embodiment will be described. As shown in Fig. 1, the component supply device 20 is a device that supplies electronic components 8 to a chip mounter 2. The electronic components 8, which are supplied by the component supply device 20, are conveyed and mounted on a circuit substrate (not illustrated) by a head 4 of the chip mounter 2. A nozzle 6, which sucks the electronic component 8, is mounted on the head 4 of the chip mounter 2.

As shown in Fig. 1, the component supply device 20 includes a housing 22, a magazine 24 that is received in the housing 22, and a plurality of pallets 10 that are set in the magazine 24. The magazine 24 includes a plurality of receiving sections 36. Each of the receiving sections 36 can receive at least one pallet 10. The plurality of receiving sections 36 are arranged in a vertical direction. A supply port 32 and a door 34, which opens and closes the supply port 32, are provided on the front surface of the housing 22 (on the left side in Fig. 1). A worker can set the pallets 10 in the magazine 24 or can take the pallets 10 out of the magazine 24 through the supply port 32.

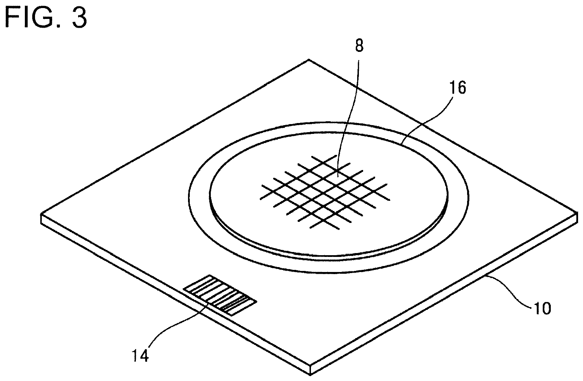

The pallet 10 is a kind of holder that holds the electronic components 8. Figs. 2 and 3 show specific examples of the pallet 10. The pallet 10 shown in Fig. 2 is called, for example, a tray pallet and can hold a tray 12 in which a plurality of electronic components 8 are received in a lattice shape. The pallet 10 shown in Fig. 3 is called, for example, a wafer pallet and can hold the electronic components 8 that are formed by dicing a semiconductor wafer 16. In the component supply device 20, the electronic components 8 are set on the pallets 10 and the pallets 10 are set in the magazine 24. Accordingly, the electronic components 8 are supplied. A bar code 14, which allows one pallet 10 to be identified from the other pallets 10, is attached to each of the pallets 10. Meanwhile, the bar code 14 is an example of an identifier, and may be other identifiers in which identification information can be recorded, such as a two-dimensional code, a magnetic tape, and an RFID. The bar code 14 may be an identifier in which identification information is recorded by the arrangement of recesses and protrusions.

As shown in Fig. 1, the component supply device 20 includes a lifting unit 30 that moves the magazine 24 up and down in the housing 22 and a take-out unit 28 that takes the pallet 10 out of the magazine 24. The take-out unit 28 extends into the chip mounter 2, and conveys the pallet 10 to a movable range of the head 4. The housing 22 is provided with a take-out port 26 through which the pallet 10 passes. The lifting unit 30 moves the magazine 24 up and down, so that a pallet 10 to be taken out by the take-out unit 28 is determined.

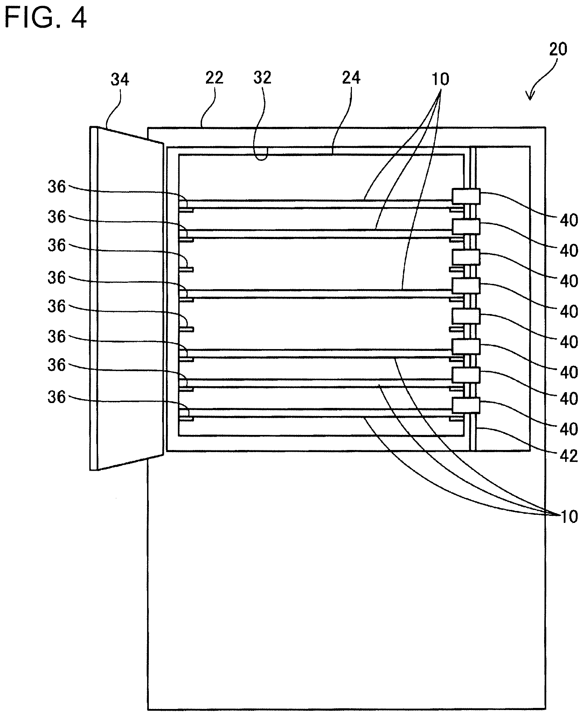

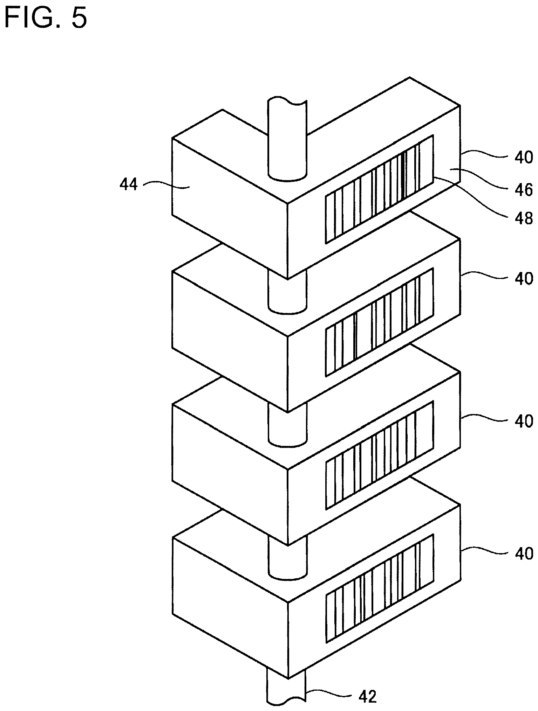

As shown in Figs. 4 and 5, the component supply device 20 includes a plurality of movable members 40. The plurality of movable members 40 are provided in the plurality of receiving sections 36, respectively. Each of the movable members 40 is rotatably supported by a shaft 42. One bar code 48 is attached to each of the movable members 40. The bar code 48 is attached to a side surface 46 of the movable member 40. Identification information about one corresponding receiving section 36 is recorded in each bar code 48, and each bar code 48 is mounted on the movable member 40 that is provided on one corresponding receiving section 36. Since front surfaces 44 of the movable members 40 are exposed to the outside in a normal time as shown in Figs. 4 and 5, the bar codes 48 are not seen normally in the supply port 32.

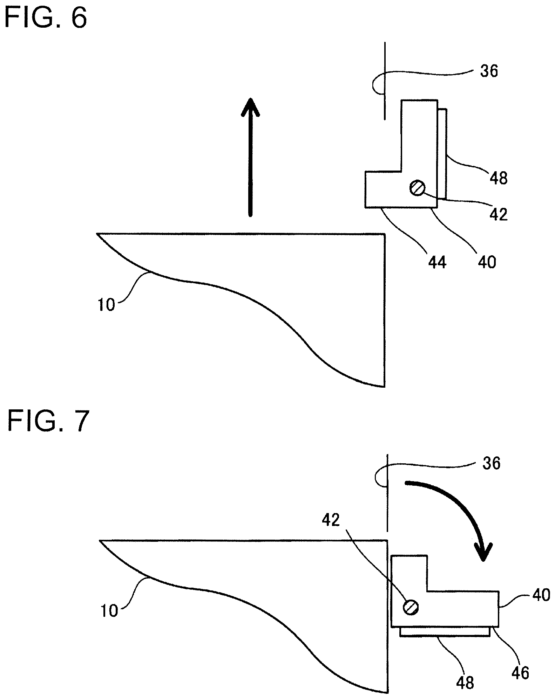

When a worker sets the pallet 10 in the receiving section 36 as shown in Fig. 6, the pallet 10 comes into contact with the front surface 44 of the movable member 40. As a result, the movable member 40 is rotated by an angle of about 90° as shown in Fig. 7. That is, the movable member 40 is moved to a second position shown in Fig. 7 from a first position shown in Fig. 6 while interlocking with the pallet 10. When the movable member 40 is moved to the second position, the bar code 48 attached to the side surface 46 of the movable member 40 can be seen in the supply port 32. Meanwhile, the bar code 48 is an example of an identifier, and may be other identifiers in which identification information can be recorded, such as a two-dimensional code, a magnetic tape, and an RFID. The bar code 48 may be an identifier in which information is recorded by the arrangement of recesses and protrusions.

When a worker supplies the electronic components 8 to the component supply device 20 of this embodiment, the worker needs to set the electronic components 8 in designated pallets 10 and to set the pallets 10 in designated receiving sections 36. For this reason, the bar codes 14 and 48 in which identification information is recorded are attached to the plurality of pallets 10 and the plurality of receiving sections 36, respectively. These bar codes 14 and 48 are read by a reading unit (for example, a bar code reader), and can be verified by a computer. When a worker sets the pallet 10 in the receiving section 36, the bar code 14 attached to the pallet 10 and the bar code 48 assigned to the receiving section 36 are read. Accordingly, the worker can confirm whether or not the designated pallet 10 is set in the designated receiving section 36 by a computer. Therefore, it is possible to prevent a human error in which a worker mistakes a receiving section 36 in which the pallet 10 is to be set.

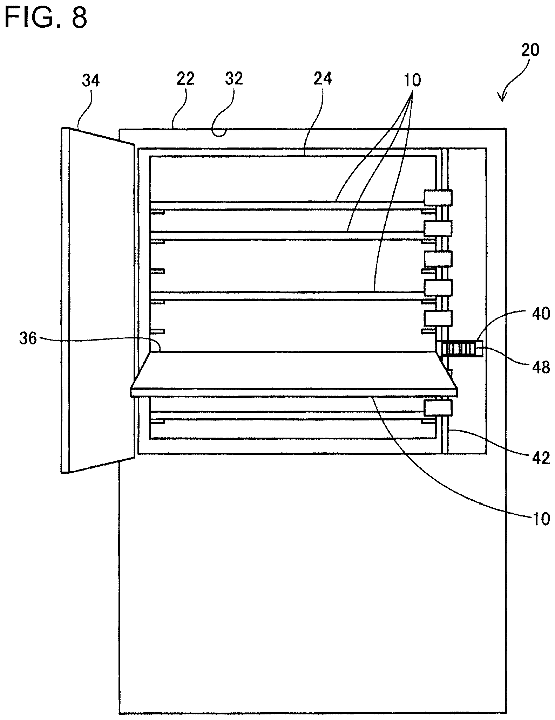

In addition, in the component supply device 20 of this embodiment, a worker is informed of the bar code 48, which is to be read when the worker sets the pallet 10 in the receiving section 36, by the movable member 40. That is, when a worker sets the pallet 10 in the receiving section 36 as shown in Fig. 8, one movable member 40 is moved to the second position. The bar code 48 of the receiving section 36 in which the pallet 10 is set is mounted on the movable member 40 that has been moved to the second position. A worker may read the bar code 48 . Accordingly, a mistake in which a worker mistakenly reads the bar code 48 assigned to the other receiving section 36 is prevented. Particularly, in this embodiment, the bar code 48 is present at a position where the bar code 48 cannot be read (that is, in the housing 22) when the movable member 40 is present at the first position, and the bar code 48 is moved to a position where the bar code 48 can be read when the movable member 40 is present at the second position. Accordingly, it is possible to more reliably prevent a worker from making a reading mistake.

### Second embodiment

A component supply device 120 of a second embodiment will be described. The component supply device 120 of this embodiment is a device that supplies electronic components 8 to a chip mounter 2. The basic structure of the component supply device 120 of this embodiment is the same as that of the component supply device 20 of the first embodiment. That is, as shown in Fig. 1, the component supply device 120 of this embodiment also includes a housing 22, a magazine 24 that is received in the housing 22, and a plurality of pallets 10 that are set in the magazine 24. The magazine 24 includes a plurality of receiving sections 36, each of which receives at least one pallet 10. A supply port 32 and a door 34, which opens and closes the supply port 32, are provided on the front surface of the housing 22. In addition, the component supply device 120 includes a lifting unit 30 that moves the magazine 24 up and down in the housing 22 and a take-out unit 28 that takes the pallet 10 out of the magazine 24. The take-out unit 28 extends into the chip mounter 2, and conveys the pallet 10 to a movable range of the head 4. The housing 22 is provided with a take-out port 26 through which the pallet 10 passes.

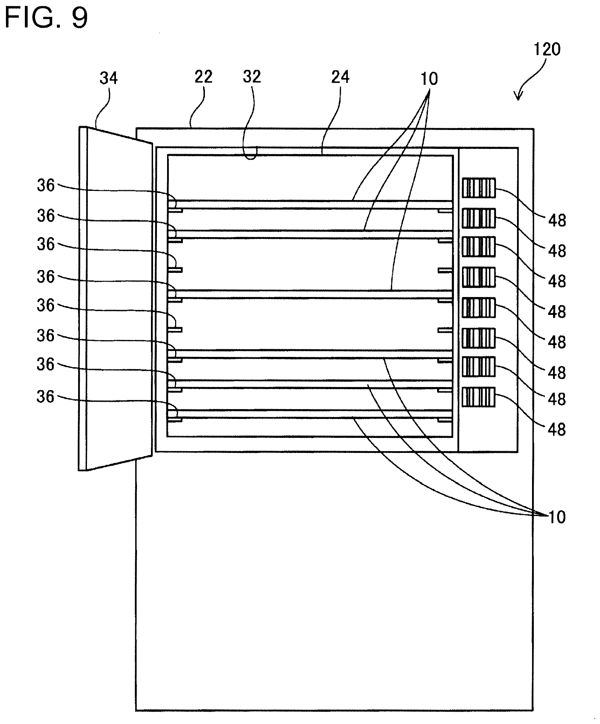

As shown in Fig. 9, the component supply device 120 of this embodiment includes a plurality of bar codes 48. The plurality of bar codes 48 are assigned to the plurality of receiving sections 36, respectively, and identification information different from one another is recorded in the plurality of bar codes 48. The plurality of bar codes 48 are fixed to the housing 22 unlike in the first embodiment.

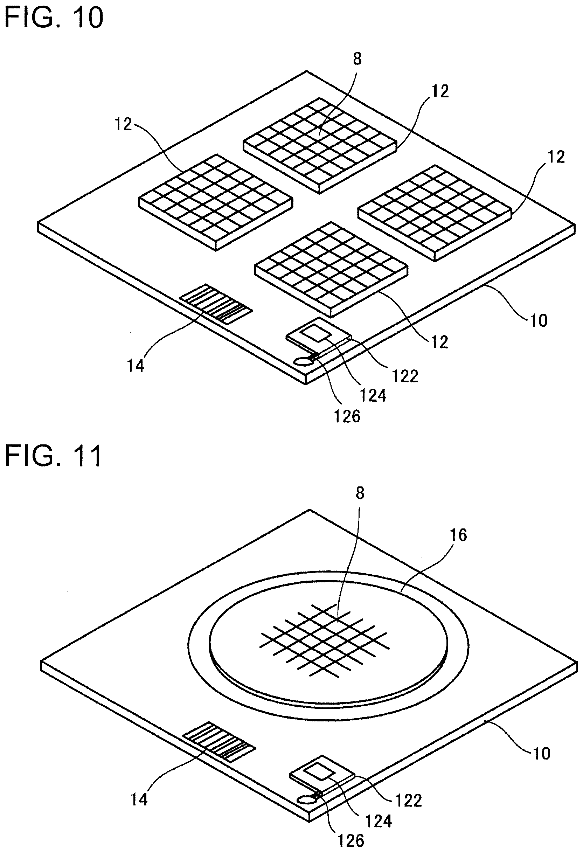

As shown in Figs. 10 and 11, the pallet 10 of this embodiment is provided with an indicating member 122. The indicating member 122 includes a window 124. The window 124 of this embodiment is a through hole, but the window 124 may be a notch. Since the indicating member 122 is mounted on the pallet 10 with a movable mechanism 126 interposed therebetween, the indicating member 122 is movably mounted on the pallet 10.

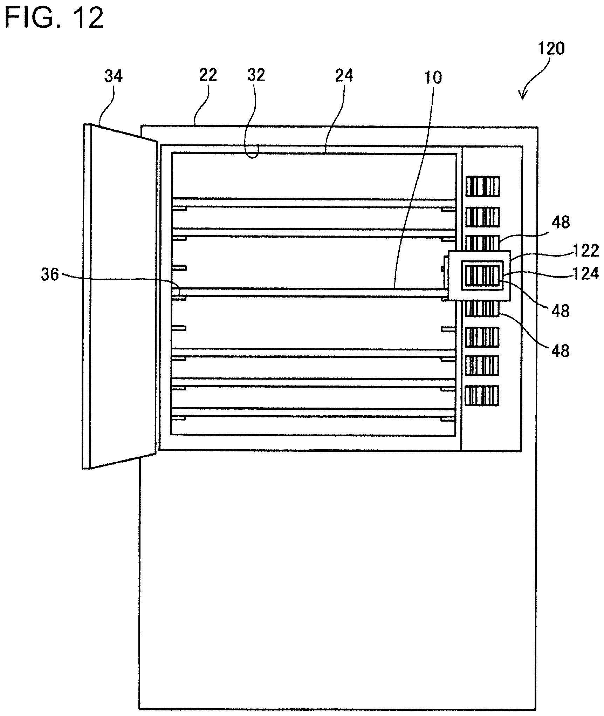

After a worker sets the pallet 10 in the receiving section 36 as shown in Fig. 12, the worker can move the indicating member 122. In this case, the indicating member 122 can be disposed so that the window 124 overlaps the bar code 48 assigned to the receiving section 36 in which the pallet 10 has been set. By this structure, a worker can know that the bar code 48 seen from the window 124 of the indicating member 122 is the bar code 48 of the receiving section 36 in which the pallet 10 has been actually set. Accordingly, a mistake in which a worker mistakenly reads the bar code 48 assigned to the other receiving section 36 is prevented.

In addition, when the window 124 is disposed so as to overlap one bar code 48, the indicating member 122 is configured so as to cover and hide at least a part of the other bar codes 48 adjacent to one bar code 48 as shown in Fig. 12. According to this structure, when a worker reads the bar code 48, which is seen from the window 124, by the reading unit, a mistake in which the reading unit unintentionally reads adjacent bar codes 48 is prevented. Accordingly, the plurality of bar codes 48 can be relatively closely disposed in the component supply device 120 of this embodiment.

### Third embodiment

A component supply device 220 of a third embodiment will be described. The component supply device 220 of this embodiment is a device that supplies electronic components 8 to a chip mounter 2. The basic structure of the component supply device 220 of this embodiment is the same as that of the component supply device 20 of the first embodiment. That is, as shown in Fig. 1, the component supply device 220 of this embodiment also includes a housing 22, a magazine 24 that is received in the housing 22, and a plurality of pallets 10 that are set in the magazine 24. The magazine 24 includes a plurality of receiving sections 36, each of which receives at least one pallet 10. A supply port 32 and a door 34, which opens and closes the supply port 32, are provided on the front surface of the housing 22. In addition, the component supply device 220 includes a lifting unit 30 that moves the magazine 24 up and down in the housing 22 and a take-out unit 28 that takes the pallet 10 out of the magazine 24. The housing 22 is provided with a take-out port 26 through which the pallet 10 passes.

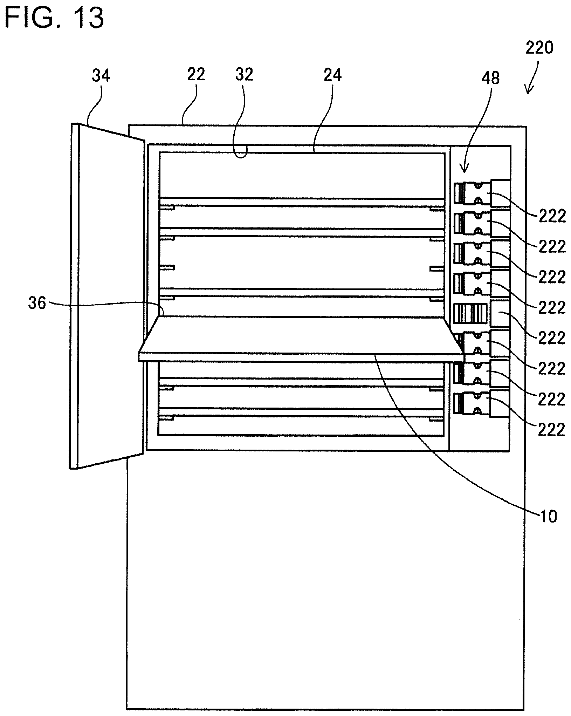

As shown in Fig. 13, the component supply device 220 of this embodiment includes a plurality of bar codes 48. The plurality of bar codes 48 are assigned to the plurality of receiving sections 36, respectively, and identification information different from one another is recorded in the plurality of bar codes 48. The plurality of bar codes 48 are fixed to the housing 22 as in the second embodiment.

The component supply device 220 of this embodiment includes a plurality of shield units 222. The plurality of bar codes 48 are provided with the plurality of shield units 222, respectively. The shield unit 222 can cover at least a part of the bar code 48 or can allow the entire bar code 48 to be exposed to the outside. All the bar codes 48 of the component supply device 220 of this embodiment are usually covered with the plurality of shield units 222 so that the bar codes 48 cannot be read. Further, when a worker sets the pallet 10 in the receiving section 36, one shield unit 222 provided on the receiving section 36 in which the pallet 10 has been set allows the bar code 48 to be exposed to the outside so that the bar code 48 can be read. By this structure, a worker can recognize that one readable bar code 48 is the bar code of the receiving section 36 in which the pallet 10 has been actually set.

As described above, the plurality of shield units 222 can allow the bar codes 48 of the receiving sections 36, in which the pallets 10 have been set, to be readable and can allow the other bar codes 48 to not be readable. Accordingly, a mistake in which a worker mistakenly reads the bar code 48 assigned to the other receiving section 36 is prevented. Here, the specific structure of the shield unit 222 is not particularly limited. The shield unit 222 may have a mechanical structure including a movable shield member, and may have an electrical structure similar with instant light control glass. Alternatively, as long as one of the plurality of bar codes 48 can be selectively read, the structure of the shield unit is not particularly limited.

### Fourth embodiment

A component supply device 320 of a fourth embodiment will be described. The component supply device 320 of this embodiment is a device that supplies electronic components 8 to a chip mounter 2. The basic structure of the component supply device 320 of this embodiment is the same as that of the component supply device 20 of the first embodiment. That is, as shown in Fig. 1, the component supply device 320 of this embodiment also includes a housing 22, a magazine 24 that is received in the housing 22, and a plurality of pallets 10 that are set in the magazine 24. The magazine 24 includes a plurality of receiving sections 36, each of which receives at least one pallet 10. A supply port 32 and a door 34, which opens and closes the supply port 32, are provided on the front surface of the housing 22. In addition, the component supply device 320 includes a lifting unit 30 that moves the magazine 24 up and down in the housing 22 and a take-out unit 28 that takes the pallet 10 out of the magazine 24. The housing 22 is provided with a take-out port 26 through which the pallet 10 passes.

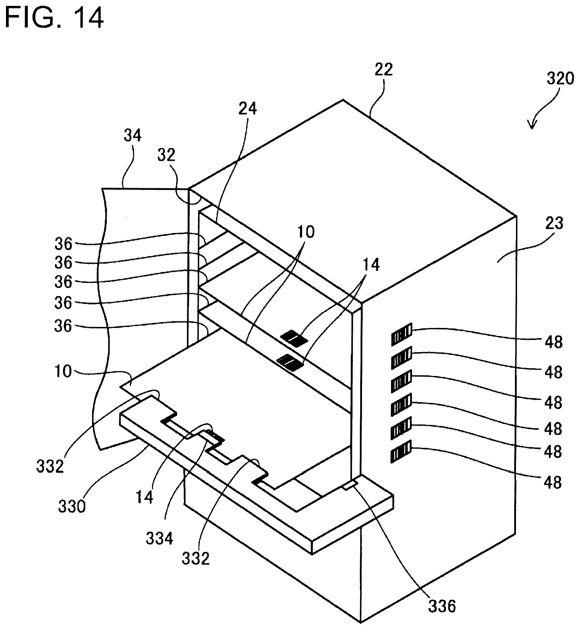

As shown in Fig. 14, the component supply device 320 of this embodiment includes a plurality of bar codes 48. The plurality of bar codes 48 are assigned to the plurality of receiving sections 36, respectively, and identification information different from one another is recorded in the plurality of bar codes 48. The plurality of bar codes 48 are fixed to the housing 22. For example, the plurality of bar codes 48 are disposed on a side surface 23 of the housing 22. The plurality of bar codes 48 are arranged in a vertical direction same as in the plurality of receiving sections 36. Further, each of the bar codes 48 is positioned at the same height as one corresponding receiving section 36.

The component supply device 320 of this embodiment includes a reading unit 330. The reading unit 330 includes two mounting portions 332, and can be mounted on the pallet 10. The reading unit 330 includes a first reading portion 336 that is used to read the bar code 48 of the receiving section 36 and a second reading portion 334 that is used to read a bar code 14 of the pallet 10. The reading unit 330 has size and weight that allows the reading unit to be carried by a worker.

According to the component supply device 320 of this embodiment, a worker can mount the reading unit 330 on a pallet 10 when setting the pallet 10 in a receiving section 36. At this time, the bar code 14 of the pallet 10 is read by the second reading portion 334. After that, when the worker sets the pallet 10 in the receiving section 36, the bar code 48 assigned to the receiving section 36 is read by the first reading portion 336. Since the bar code 48 of the receiving section 36 is automatically read in this embodiment as described above, a mistake in which a worker mistakenly reads a bar code 48 assigned to the other receiving section 36 is prevented. In addition, since the bar code 14 of the pallet 10 is also automatically read, it is possible to save time and labor of a worker.

### Fifth embodiment

A component supply device 420 of a fifth embodiment will be described. The component supply device 420 of this embodiment is a device that supplies electronic components 8 to a chip mounter 2. The basic structure of the component supply device 420 of this embodiment is the same as that of the component supply device 20 of the first embodiment. That is, as shown in Fig. 1, the component supply device 420 of this embodiment also includes a housing 22, a magazine 24 that is received in the housing 22, and a plurality of pallets 10 that are set in the magazine 24. The magazine 24 includes a plurality of receiving sections 36, each of which receives at least one pallet 10. A supply port 32 and a door 34, which opens and closes the supply port 32, are provided on the front surface of the housing 22. In addition, the component supply device 420 includes a lifting unit 30 that moves the magazine 24 up and down in the housing 22 and a take-out unit 28 that takes the pallet 10 out of the magazine 24. The housing 22 is provided with a take-out port 26 through which the pallet 10 passes.

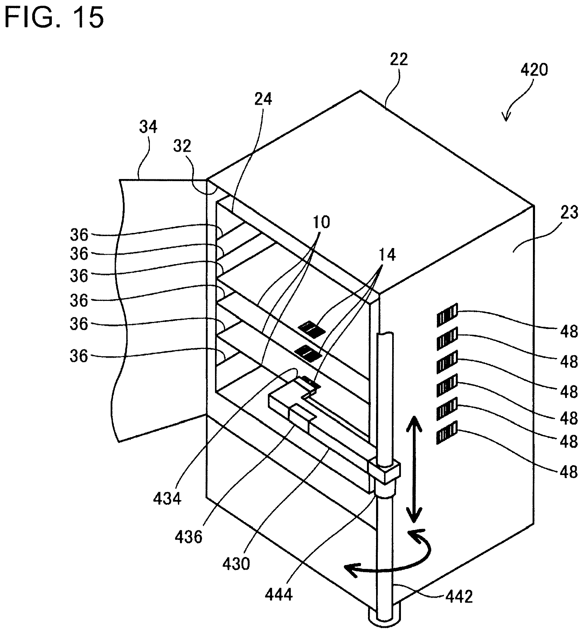

As shown in Fig. 15, the component supply device 420 of this embodiment includes a plurality of bar codes 48. The plurality of bar codes 48 are assigned to the plurality of receiving sections 36, respectively, and identification information different from one another is recorded in the plurality of bar codes 48. The plurality of bar codes 48 are fixed to the housing 22. For example, the plurality of bar codes 48 are disposed on a side surface 23 of the housing 22. The plurality of bar codes 48 are arranged in a vertical direction same as in the plurality of receiving sections 36. Further, each of the bar codes 48 is positioned at the same height as one corresponding receiving section 36.

The component supply device 420 of this embodiment includes a reading unit 430. The reading unit 430 includes a first reading portion 436 that is used to read the bar code 48 of the receiving section 36 and a second reading portion 434 that is used to read a bar code 14 of the pallet 10. The reading unit 430 of this embodiment is supported by a shaft 442. The shaft 442 is fixed to the housing 22, and extends in the vertical direction. The shaft 442 supports the reading unit 430 so that the reading unit 430 is movable in the vertical direction, and supports the reading unit 430 so that the reading unit 430 is rotatable in a horizontal direction. Further, the reading unit 430 is provided with a lock mechanism 444. The lock mechanism 444 can allow/prevent the movement of the reading unit 430 in the vertical direction that is caused by the shaft 442.

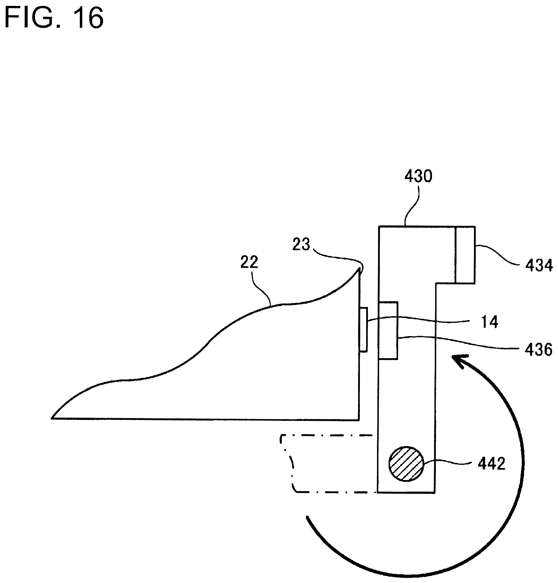

According to the component supply device 420 of this embodiment, a worker can read the bar code 14 of a pallet 10 by moving the reading unit 430 after setting the pallet 10 in the receiving section 36. After that, when the worker rotates the reading unit 430 in the horizontal direction as shown in Fig. 16 after preventing the movement of the reading unit 430 in the vertical direction by the lock mechanism 444, the worker can read one bar code 48 that is disposed on the side surface 23 of the housing 22. This bar code 48 is a bar code 48 that is assigned to the receiving section 36 in which the worker has set the pallet 10. The worker can read a correct bar code 48 by following a predetermined procedure as described above. Accordingly, it is possible to avoid a mistake in which the worker mistakenly reads a bar code 48 assigned to the other receiving section 36.

### Example which is not claimed but is useful for understanding the invention

A component supply device 520 of an example which is not claimed but is useful for understanding the invention will be described. The component supply device 520 of this example is a device that supplies electronic components 8 to a chip mounter 2. The basic structure of the component supply device 520 of this example is the same as that of the component supply device 20 of the first embodiment. That is, as shown in Fig. 1, the component supply device 520 of this example also includes a housing 22, a magazine 24 that is received in the housing 22, and a plurality of pallets 10 that are set in the magazine 24. The magazine 24 includes a plurality of receiving sections 36, each of which receives at least one pallet 10. A supply port 32 and a door 34, which opens and closes the supply port 32, are provided on the front surface of the housing 22. In addition, the component supply device 520 includes a lifting unit 30 that moves the magazine 24 up and down in the housing 22 and a take-out unit 28 that takes the pallet 10 out of the magazine 24. The housing 22 is provided with a take-out port 26 through which the pallet 10 passes.

The component supply device 520 of this example includes a reading unit 530, a shaft 542 that supports the reading unit 530, an electronic scale 544 that is provided on the shaft 542, and a decoder 546 that reads the electronic scale 544. The reading unit 530 includes a reading portion 534 that is used to read a bar code 14 of the pallet 10. The shaft 542 is fixed to the housing 22, and extends in a vertical direction. The shaft 542 supports the reading unit 530 so that the reading unit 530 is movable in the vertical direction, and supports the reading unit 530 so that the reading unit 530 is rotatable in a horizontal direction. The decoder 546 can detect the height position of the reading unit 530 by reading the electronic scale 544. That is, the decoder 546 can detect the position of the reading unit 530 in the vertical direction where the plurality of receiving sections 36 are arranged.

In the component supply device 520 of this example, a worker can read the bar code 14 of a pallet 10 by moving the reading unit 530 after setting the pallet 10 in the receiving section 36. When the reading unit 530 reads the bar code 14 of the pallet 10, the decoder 546 detects the height position of the reading unit 530. The height position of the reading unit 530 at this time corresponds to one receiving section 36 in which a worker has set the pallet 10. Accordingly, the receiving section 36 in which a worker actually has set the pallet 10 can be specified from the height position of the reading unit 530. Since a worker does not need to read an
identifier such as a bar code, a human error that is caused by the worker is prevented.

### Sixth embodiment

A component supply device 620 of a sixth embodiment will be described. The component supply device 620 of this embodiment is a device that supplies electronic components 8 to a chip mounter 2. The basic structure of the component supply device 620 of this embodiment is the same as that of the component supply device 20 of the first embodiment. That is, as shown in Fig. 1, the component supply device 620 of this embodiment also includes a housing 22, a magazine 24 that is received in the housing 22, and a plurality of pallets 10 that are set in the magazine 24. The magazine 24 includes a plurality of receiving sections 36, each of which receives at least one pallet 10. A supply port 32 and a door 34, which opens and closes the supply port 32, are provided on the front surface of the housing 22. In addition, the component supply device 620 includes a lifting unit 30 that moves the magazine 24 up and down in the housing 22 and a take-out unit 28 that takes the pallet 10 out of the magazine 24. The housing 22 is provided with a take-out port 26 through which the pallet 10 passes.

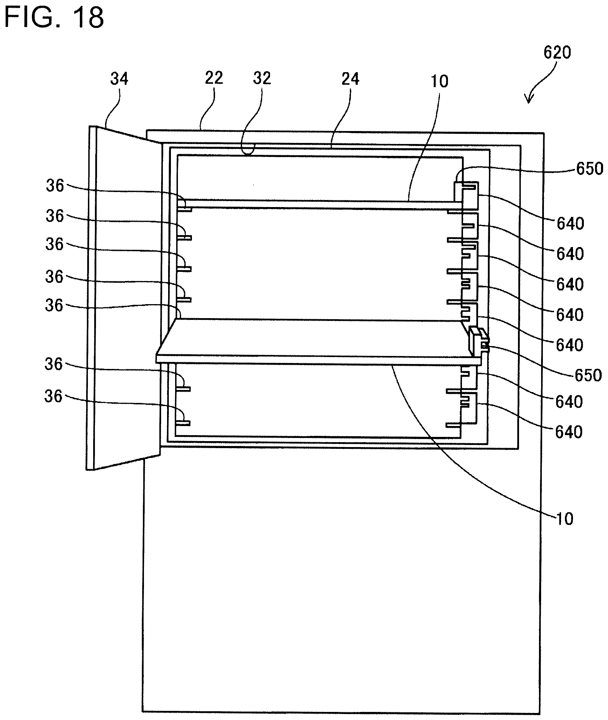

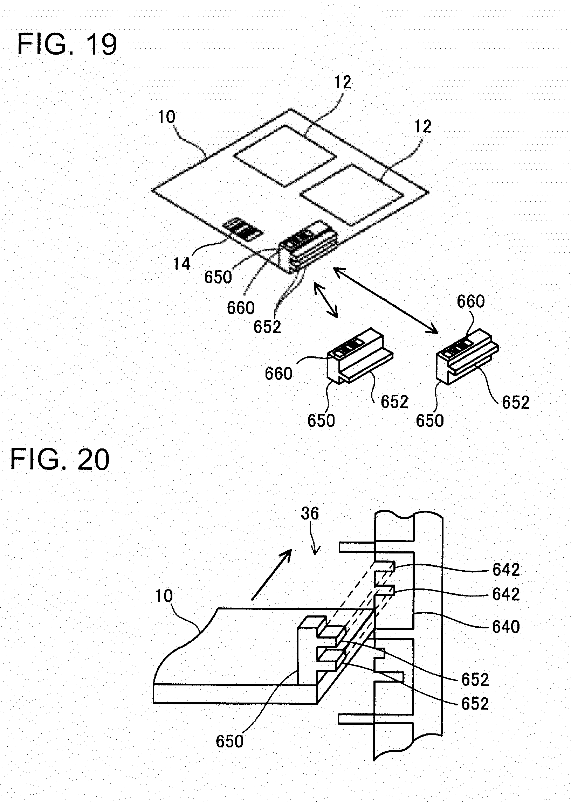

As shown in Fig. 18, the component supply device 620 of this embodiment includes a plurality of gate jigs 640 and a plurality of key jigs 650. Each of the gate jigs 640 includes one or a plurality of grooves 642 (see Fig. 20), and has a shape different from the shapes of the other gate jigs 640 . Meanwhile, each of the key jigs 650 includes one or a plurality of protrusions 652 (see Figs. 19 and 20), and has a shape different from the shapes of the other key jigs 650. The plurality of gate jigs 640 are fixed to the plurality of receiving sections 36, respectively. Meanwhile, when a worker sets a pallet 10 in the receiving section 36, the key jig 650 is mounted on the pallet 10. Each key jig 650 has a shape that allows the key jig 650 to be fitted to one corresponding gate jig 640 and not to be fitted to the other gate jig 640.

When the electronic components 8 are supplied to the component supply device 620, a pallet 10 to be used and a receiving section 36 in which the pallet 10 is to be set are designated. As shown in Fig. 19, a worker places trays 12 of the electronic components 8, which are to be supplied, on the designated pallet 10, and selects a key jig 650 for the designated receiving section 36 and mounts the key jig 650 on the pallet 10. A bar code 660 is mounted on each of the key jigs 650. When the preparation of the pallet 10 is completed, a worker reads the bar code 14 of the pallet 10 and the bar code 660 of the key jig 650 by the reading unit. Accordingly, whether the combination of a pallet 10 to be used and a key jig 650 to be used is correct or not can be confirmed by a computer. After that, a worker carries the prepared pallet 10 to the component supply device 620, and sets the pallet 10 in the designated receiving section 36.

As shown in Fig. 20, the key jig 650 mounted on the pallet 10 is fitted to the gate jig 640 of the designated receiving section 36 but is not fitted to the gate jig 640 of the other receiving section 36. That is, since the gate jigs 640 are mounted on the respective receiving sections 36, a pallet 10 on which a corresponding key jig 650 is mounted can be received in the receiving section 36 but a pallet 10 on which the other key jig 650 is mounted cannot be received in the receiving section 36. Accordingly, since the pallet 10 can be set only in a correct receiving section 36, a mistake in which a worker sets a pallet 10 in a wrong receiving section 36 is prevented.

Embodiments of the invention have been described in detail above, but these embodiments are merely illustrative and do not limit claims. Various modifications and alterations of the above-mentioned embodiments are included in techniques disclosed in claims. Technical elements, which have been disclosed in this specification or drawings, exert technical usability alone or by the various combinations thereof, and are not limited to the combinations disclosed in the claims provided at the time of application. Further, the technique disclosed in this specification or drawings simultaneously achieves a plurality of objects, and has technical usability by achieving one object among the objects.

## Claims

1. A component supply device (20) that supplies electronic components (8) to a chip mounter (2), the component supply device (20) comprising:
holders (10), each of which holds at least one electronic component (8);
a plurality of receiving sections (36), each of which receives one of the holders (10);
a plurality of first identifiers (48), each of which is assigned to one of the plurality of receiving sections (36), respectively; and
an information mechanism that informs a worker of the first identifier (48) assigned to the receiving section (36) in which the holder (10) has been set when the worker sets the holder (10) in the receiving section (36);
wherein the information mechanism includes a plurality of movable members (40), each of which is provided on one of the plurality of receiving sections (36), respectively,
each of the plurality of first identifiers (48) is mounted on a movable member (40) provided on one corresponding receiving section (36), and
when a worker sets a holder (10) in a receiving section (36), the movable member (40) provided on the receiving section (36) is moved to a second position from a first position while interlocking with an operation of the holder (10).

2. The component supply device (20) according to claim 1,
wherein the first identifier (36) is not readable when the movable member (40) is moved to the first position, and the first identifier (36) is readable when the movable member (40) is moved to the second position.

3. A component supply device (120) that supplies electronic components (8) to a chip mounter (2), the component supply device (120) comprising:
holders (10), each of which holds at least one electronic component (8);
a plurality of receiving sections (36), each of which receives one of the holders (10);
a plurality of first identifiers (48), each of which is assigned to one of the plurality of receiving sections (36), respectively; and
an information mechanism that informs a worker of the first identifier (48) assigned to the receiving section (36) in which the holder (10) has been set when the worker sets the holder (10) in the receiving section (36);
wherein the information mechanism includes indicating members (122), each of which is provided on one of the holders (10) and includes a window portion (124), and
when a worker sets a holder (10) in a receiving section (36), the indicating member (122) provided on the holder (10) is disposed so that the window portion (124) overlaps the first identifier (48) assigned to the receiving section (36) in which the holder (10) is set.

4. The component supply device (120) according to claim 3,
wherein the indicating member (122) covers and hides at least a part of the other first identifiers (48) adjacent to the one first identifier (48), when the indicating member (122) is disposed so that the window portion (124) overlaps one first identifier (48).

5. A component supply device (220) that supplies electronic components (8) to a chip mounter (2), the component supply device (220) comprising:
holders (10), each of which holds at least one electronic component (8);
a plurality of receiving sections (36), each of which receives one of the holders (10);
a plurality of first identifiers (48), each of which is assigned to one of the plurality of receiving sections (36), respectively; and
an information mechanism that informs a worker of the first identifier (48) assigned to the receiving section (36) in which the holder (10) has been set when the worker sets the holder (10) in the receiving section (36);
wherein the information mechanism includes a plurality of shield units (222), each of which can cover at least part of a first identifier (48) or can allow the respective first identifier (48) to be exposed entirely to the outside,
wherein when a worker sets the holder (10) in the receiving section (36), the information mechanism allows the first identifier (48) assigned to the receiving section (36), in which the holder (10) is set, to be readable by exposing the first identifier (48) to the outside and does not allow the other first identifiers (48) to be readable by covering the other first identifiers (48) by respective shield units (222).

6. The component supply device (220) according to any one of claims 1 to 5,
wherein the first identifier (48) is a bar code or a two-dimensional code.

7. A component supply device (320) that supplies electronic components (8) to a chip mounter (2), the component supply device (320) comprising:
holders (10), each of which holds at least one electronic component (8);
a plurality of receiving sections (36), each of which receives one of the holders (10);
a plurality of first identifiers (48), each of which is assigned to one of the plurality of receiving sections (36), respectively; and
a reading unit (330) that reads at least the first identifier (48) assigned to the receiving section (36) when a worker sets the holder (10) in the receiving section (36),
wherein the reading unit (330) is mountable to one of the holders (10) by a worker when setting the holder (10) in a receiving section (36).

8. The component supply device (320) according to claim 7,
wherein when the reading unit (330) is mounted on the holder (10), the reading unit (330) further reads a second identifier (14) attached to the holder (10).

9. A component supply device (420) that supplies electronic components (8) to a chip mounter (2), the component supply device (420) comprising:
holders (10), each of which holds at least one electronic component (8) and to each of which a second identifier (14) is attached;
a plurality of receiving sections (36), each of which receives one of the holders (10);
a plurality of first identifiers (48), each of which is assigned to one of the plurality of receiving sections (36), respectively;
a reading unit (430) that is configured to read the first identifiers (48) and the second identifiers (14);
a first support mechanism (442) that supports the reading unit (430) so that the reading unit (430) is movable in a first direction;
a second support mechanism (442) that supports the reading unit (430) so that the reading unit (430) is rotatable in a second direction; and
a lock mechanism (444) that allows/prevents the movement of the reading unit in the first direction that is caused by the first support mechanism (442),
wherein when the reading unit (430) is rotated by the second support mechanism (442) from a position, at which the reading unit (430) is configured to read the second identifier (14) of a holder (10) set in a receiving section (36), in the second direction, the reading unit (430) reaches a position at which the reading unit (430) is configured to read the first identifier (48) assigned to the receiving section (36).

10. The component supply device (420) according to claim 9,
wherein the plurality of receiving sections (36) are arranged in a vertical direction and wherein the plurality of first identifiers (48) are arranged in a vertical direction, and/or wherein each of the plurality of first identifiers (48) is positioned at the same height as one corresponding receiving section (36).

11. A component supply device (620) that supplies electronic components (8) to a chip mounter (2), the component supply device (620) comprising:
holders (10), each of which holds at least one electronic component (8);
a plurality of receiving sections (36), each of which receives one of the holders (10);
a plurality of gate jigs (640), each of which is fixed to one of the plurality of receiving sections (36), respectively, and
a plurality of key jigs (650), each of which being selectively mountable on one of the holders (10),
wherein the plurality of gate jigs (640) have shapes different from one another, and
each of the plurality of gate jigs (640) has a shape that allows the receiving section (36) to receive a holder (10) on which one corresponding key jig (650) among the plurality of jigs (650) is mounted and does not allow the receiving section (36) to receive the holders (10) on which the other key jigs (650) are mounted.

## Patentansprüche

1. Komponentenzuführvorrichtung (20), die einem Chipbestückungsautomaten (2) elektronische Komponenten (8) zuführt, wobei die Komponentenzuführvorrichtung (20) umfasst:
Haltevorrichtungen (10), von denen jede mindestens eine elektronische Komponente (8) hält;
eine Vielzahl von Aufnahmeteilen (36), von denen jedes eine der Haltevorrichtungen (10) aufnimmt;
eine Vielzahl von ersten Bezeichnern (48), von denen jeder jeweils einem der Vielzahl von Aufnahmeteilen (36) zugeordnet ist; und
einen Informationsmechanismus, der einen Arbeiter über den ersten Bezeichner (48) informiert, der dem Aufnahmeteil (36) zugeordnet ist, in welches die Haltevorrichtung (10) gesetzt wurde, wenn der Arbeiter die Haltevorrichtung (10) in das Aufnahmeteil (36) setzt;
wobei der Informationsmechanismus eine Vielzahl bewegbarer Elemente (40) einschließt, von denen jedes jeweils auf einem der Vielzahl von Aufnahmeteilen (36) vorgesehen ist,
jeder der Vielzahl von ersten Bezeichnern (48) auf einem bewegbaren Element (40), das auf einem entsprechenden Aufnahmeteil (36) vorgesehen ist, montiert wird, und
wenn ein Arbeiter eine Haltevorrichtung (10) in ein Aufnahmeteil (36) setzt, das auf dem Aufnahmeteil (36) vorgesehene bewegbare Element (40) von einer ersten Position in eine zweite Position bewegt wird, während es mit einem Arbeitsvorgang der Haltevorrichtung (10) verkettet wird.

2. Komponentenzuführvorrichtung (20) nach Anspruch 1,
wobei der erste Bezeichner (36) nicht lesbar ist, wenn das bewegbare Element (40) in die erste Position bewegt wird, und der erste Bezeichner (36) lesbar ist, wenn das bewegbare Element (40) in die zweite Position bewegt wird.

3. Komponentenzuführvorrichtung (120), die einem Chipbestückungsautomaten (2) elektronische Komponenten (8) zuführt, wobei die Komponentenzuführvorrichtung (120) umfasst:
Haltevorrichtungen (10), von denen jede mindestens eine elektronische Komponente (8) hält;
eine Vielzahl von Aufnahmeteilen (36), von denen jedes eine der Haltevorrichtungen (10) aufnimmt;
eine Vielzahl von ersten Bezeichnern (48), von denen jeder jeweils einem der Vielzahl von Aufnahmeteilen (36) zugeordnet ist; und
einen Informationsmechanismus, der einen Arbeiter über den ersten Bezeichner (48) informiert, der dem Aufnahmeteil (36) zugeordnet ist, in welches die Haltevorrichtung (10) gesetzt wurde, wenn der Arbeiter die Haltevorrichtung (10) in das Aufnahmeteil (36) setzt;
wobei der Informationsmechanismus Anzeigeelemente (122) einschließt, von denen jedes auf einer der Haltevorrichtungen (10) vorgesehen ist und einen Arbeitsöffnungsteil (124) einschließt, und
wenn ein Arbeiter eine Haltevorrichtung (10) in ein Aufnahmeteil (36) setzt, das auf der Haltevorrichtung (10) vorgesehene Anzeigeelement (122) so angeordnet ist, dass der Arbeitsöffnungsteil (124) den ersten Bezeichner (48) überdeckt, der dem Aufnahmeteil (36), in welches die Haltevorrichtung (10) gesetzt wird, zugeordnet ist.

4. Komponentenzuführvorrichtung (120) nach Anspruch 3,
wobei das Anzeigeelement (122) zumindest einen Teil des dem einen ersten Bezeichner (48) benachbarten, anderen ersten Bezeichners (48) bedeckt und verbirgt, wenn das Anzeigeelement (122) so angeordnet ist, dass der Arbeitsöffnungsteil (124) einen ersten Bezeichner (48) überdeckt.

5. Komponentenzuführvorrichtung (220), die einem Chipbestückungsautomaten (2) elektronische Komponenten (8) zuführt, wobei die Komponentenzuführvorrichtung (220) umfasst:
Haltevorrichtungen (10), von denen jede mindestens eine elektronische Komponente (8) hält;
eine Vielzahl von Aufnahmeteilen (36), von denen jedes eine der Haltevorrichtungen (10) aufnimmt;
eine Vielzahl von ersten Bezeichnern (48), von denen jeder jeweils einem der Vielzahl von Aufnahmeteilen (36) zugeordnet ist; und
einen Informationsmechanismus, der einen Arbeiter über den ersten Bezeichner (48) informiert, der dem Aufnahmeteil (36) zugeordnet ist, in welches die Haltevorrichtung (10) gesetzt wurde, wenn der Arbeiter die Haltevorrichtung (10) in das Aufnahmeteil (36) setzt;
wobei der Informationsmechanismus eine Vielzahl von Abschirmungseinheiten (222) umfasst, von denen jede zumindest einen Teil eines ersten Bezeichners (48) bedecken kann oder dem jeweiligen ersten Bezeichner (48) erlauben kann, nach außen völlig freigelegt zu werden,
wobei, wenn ein Arbeiter die Haltevorrichtung (10) in das Aufnahmeteil (36) setzt, der Informationsmechanismus dem ersten Bezeichner (48), der dem Aufnahmeteil (36) zugeordnet ist, in welches die Haltevorrichtung (10) gesetzt wird, erlaubt, lesbar zu sein, indem der erste Bezeichner (48) nach außen freigelegt wird, und den anderen ersten Bezeichnern (48) nicht erlaubt, lesbar zu sein, indem die anderen ersten Bezeichner (48) durch jeweilige Abschirmungseinheiten (222) bedeckt werden.

6. Komponentenzuführvorrichtung (220) nach einem der Ansprüche 1 bis 5,
wobei der erste Bezeichner (48) ein Strichcode oder ein zweidimensionaler Code ist.

7. Komponentenzuführvorrichtung (320), die einem Chipbestückungsautomaten (2) elektronische Komponenten (8) zuführt, wobei die Komponentenzuführvorrichtung (320) umfasst:
Haltevorrichtungen (10), von denen jede mindestens eine elektronische Komponente (8) hält;
eine Vielzahl von Aufnahmeteilen (36), von denen jedes eine der Haltevorrichtungen (10) aufnimmt;
eine Vielzahl von ersten Bezeichnern (48), von denen jeder jeweils einem der Vielzahl von Aufnahmeteilen (36) zugeordnet ist; und
eine Leseeinheit (330), die zumindest den ersten, dem Aufnahmeteil (36) zugeordneten ersten Bezeichner (48) liest, wenn ein Arbeiter die Haltevorrichtung (10) in das Aufnahmeteil (36) setzt,
wobei die Leseeinheit (330) an einer der Haltevorrichtungen (10) von einem Arbeiter montierbar ist, wenn die Haltevorrichtung (10) in ein Aufnahmeteil (36) gesetzt wird.

8. Komponentenzuführvorrichtung (320) nach Anspruch 7,
wobei, wenn die Leseeinheit (330) auf der Haltevorrichtung (10) montiert ist, die Leseeinheit (330) des Weiteren einen an der Haltevorrichtung (10) befestigten zweiten Bezeichner (14) liest.

9. Komponentenzuführvorrichtung (420), die einem Chipbestückungsautomaten (2) elektronische Komponenten (8) zuführt, wobei die Komponentenzuführvorrichtung (420) umfasst:
Haltevorrichtungen (10), von denen jede mindestens eine elektronische Komponente (8) hält und an jeder davon ein zweiter Bezeichner (14) befestigt ist;
eine Vielzahl von Aufnahmeteilen (36), von denen jedes eine der Haltevorrichtungen (10) aufnimmt;
eine Vielzahl von ersten Bezeichnern (48), von denen jeder jeweils einem der Vielzahl von Aufnahmeteilen (36) zugeordnet ist;
eine Leseeinheit (430), die gestaltet ist, die ersten Bezeichner (48) und die zweiten Bezeichner (14) zu lesen;
einen ersten Stützmechanismus (442), der die Leseeinheit (430) unterstützt, so dass die Leseeinheit (430) in einer ersten Richtung bewegbar ist;
einen zweiten Stützmechanismus (442), der die Leseeinheit (430) unterstützt, so dass die Leseeinheit (430) in einer zweiten Richtung rotierbar ist; und
einen Sperrmechanismus (444), der die Bewegung der Leseeinheit in der ersten Richtung, die durch den ersten Stützmechanismus (442) bewirkt wird, erlaubt/verhindert,
wobei, wenn die Leseeinheit (430) durch den zweiten Stützmechanismus (442) von einer Position, in der die Leseeinheit (430) ausgelegt ist, den zweiten Bezeichner (14) einer in ein Aufnahmeteil (36) gesetzten Haltevorrichtung (10) zu lesen, in die zweite Richtung rotiert wird, die Leseeinheit (430) eine Position erreicht, bei der die Leseeinheit (430) gestaltet ist, den dem Aufnahmeteil (36) zugeordneten ersten Bezeichner (48) zu lesen.

10. Komponentenzuführvorrichtung (420) nach Anspruch 9,
wobei die Vielzahl von Aufnahmeteilen (36) in einer vertikalen Richtung angeordnet ist, und wobei die Vielzahl von ersten Bezeichnern (48) in einer vertikalen Richtung angeordnet ist, und/oder wobei jeder der Vielzahl von ersten Bezeichnern (48) in der gleichen Höhe wie ein entsprechendes Aufnahmeteil (36) positioniert ist.

11. Komponentenzuführvorrichtung (620), die einem Chipbestückungsautomaten (2) elektronische Komponenten (8) zuführt, wobei die Komponentenzuführvorrichtung (620) umfasst:
Haltevorrichtungen (10), von denen jede mindestens eine elektronische Komponente (8) hält;
eine Vielzahl von Aufnahmeteilen (36), von denen jedes eine der Haltevorrichtungen (10) aufnimmt;
eine Vielzahl von Klappeneinspannvorrichtungen (640), von denen jede jeweils an einem der Vielzahl von Aufnahmeteilen (36) befestigt ist; und
eine Vielzahl von Keileinspannvorrichtungen (650), von denen jede selektiv auf einer der Haltevorrichtungen (10) montierbar ist,
wobei die Vielzahl von Klappeneinspannvorrichtungen (640) voneinander unterschiedliche Formen aufweisen, und
jede der Vielzahl von Klappeneinspannvorrichtungen (640) eine Form besitzt, die es erlaubt, dass das Aufnahmeteil (36) eine Haltevorrichtung (10) aufnimmt, auf der eine entsprechende Keileinspannvorrichtung (650) unter der Vielzahl von Einspannvorrichtungen (650) montiert ist, und es dem Aufnahmeteil (36) nicht erlaubt, die Haltevorrichtungen (10), auf denen die anderen Keileinspannvorrichtungen (650) montiert sind, aufzunehmen.

## Revendications

1. Dispositif d'alimentation de composants (20) qui alimente des composants électroniques (8) à un monteur de puces (2), le dispositif d'alimentation de composants (20) comprenant :
des porteurs (10), qui portent chacun au moins un composant électronique (8) ;
une pluralité de sections de réception (36), qui reçoivent chacune l'un des porteurs (10) ;
une pluralité de premiers identifiants (48), qui sont respectivement assignés chacun à une section de la pluralité de sections de réception (36) ; et
un mécanisme d'information qui informe un travailleur du premier identifiant (48) assigné à la section de réception (36) dans laquelle le porteur (10) a été placé quand le travailleur place le porteur (10) dans la section de réception (36) ;
dans lequel le mécanisme d'information comprend une pluralité d'éléments mobiles (40), qui sont respectivement pourvus chacun sur une section de la pluralité de sections de réception (36),
chaque identifiant de la pluralité de premiers identifiants (48) est monté sur un élément mobile (40) pourvu sur une section de réception correspondante (36), et
quand un travailleur place un porteur (10) dans une section de réception (36), l'élément mobile (40) pourvu sur la section de réception (36) est déplacé jusqu'à une deuxième position depuis une première position tout en s'interverrouillant par un actionnement du porteur (10).

2. Dispositif d'alimentation de composants (20) selon la revendication 1,
dans lequel le premier identifiant (36) n'est pas lisible quand l'élément mobile (40) est déplacé jusqu'à la première position, et le premier identifiant (36) est lisible quand l'élément mobile (40) est déplacé jusqu'à la deuxième position.

3. Dispositif d'alimentation de composants (120) qui alimente des composants électroniques (8) à un monteur de puces (2), le dispositif d'alimentation de composants (120) comprenant :
des porteurs (10), qui portent chacun au moins un composant électronique (8) ;
une pluralité de sections de réception (36), qui reçoivent chacune l'un des porteurs (10) ;
une pluralité de premiers identifiants (48), qui sont respectivement assignés chacun à une section de la pluralité de sections de réception (36) ; et
un mécanisme d'information qui informe un travailleur du premier identifiant (48) assigné à la section de réception (36) dans laquelle le porteur (10) a été placé quand le travailleur place le porteur (10) dans la section de réception (36) ;
dans lequel le mécanisme d'information comprend des éléments indicatifs (122), qui chacun sont pourvus sur l'un des porteurs (10) et comprennent une portion de fenêtre (124), et
quand un travailleur place un porteur (10) dans une section de réception (36), l'élément indicatif (122) pourvu sur le porteur (10) est disposé de telle sorte que la portion de fenêtre (124) chevauche le premier identifiant (48) assigné à la section de réception (36) dans laquelle le porteur (10) est placé.

4. Dispositif d'alimentation de composants (120) selon la revendication 3,
dans lequel l'élément indicatif (122) recouvre et cache au moins une partie des autres premiers identifiants (48) adjacents audit premier identifiant (48) quand l'élément indicatif (122) est disposé de telle sorte que la portion de fenêtre (124) chevauche un premier identifiant (48) .

5. Dispositif d'alimentation de composants (220) qui alimente des composants électroniques (8) à un monteur de puces (2), le dispositif d'alimentation de composants (220) comprenant :
des porteurs (10), qui portent chacun au moins un composant électronique (8) ;
une pluralité de sections de réception (36), qui reçoivent chacune l'un des porteurs (10) ;
une pluralité de premiers identifiants (48), qui sont chacun assignés respectivement à une section de la pluralité de sections de réception (36) ; et
un mécanisme d'information qui informe un travailleur du premier identifiant (48) assigné à la section de réception (36) dans laquelle le porteur (10) a été placé quand le travailleur place le porteur (10) dans la section de réception (36) ;
dans lequel le mécanisme d'information comprend une pluralité d'unités de protection (222), qui peuvent chacune recouvrir au moins une partie d'un premier identifiant (48) ou permettre au premier identifiant respectif (48) d'être entièrement exposé à l'extérieur,
dans lequel, quand un travailleur place le porteur (10) dans la section de réception (36), le mécanisme d'information permet au premier identifiant (48) assigné à la section de réception (36), dans laquelle le porteur (10) a été placé, d'être lisible en exposant le premier identifiant (48) à l'extérieur, et ne permet pas aux autres premiers identifiants (48) d'être lisibles en recouvrant les autres premiers identifiants (48) par des unités de protection respectives (222).

6. Dispositif d'alimentation de composants (220) selon l'une quelconque des revendications 1 à 5,
dans lequel le premier identifiant (48) est un code-barres ou un code bidimensionnel.

7. Dispositif d'alimentation de composants (320) qui alimente des composants électroniques (8) à un monteur de puces (2), le dispositif d'alimentation de composants (320) comprenant :
des porteurs (10), qui portent chacun au moins un composant électronique (8) ;
une pluralité de sections de réception (36), qui reçoivent chacune l'un des porteurs (10) ;
une pluralité de premiers identifiants (48), qui sont chacun assignés respectivement à une section de la pluralité de sections de réception (36) ; et
une unité de lecture (330) qui lit au moins le premier identifiant (48) assigné à la section de réception (36) quand un travailleur place le porteur (10) dans la section de réception (36),
dans lequel l'unité de lecture (330) peut être montée sur l'un des porteurs (10) par un travailleur quand le porteur (10) est placé dans une section de réception (36).

8. Dispositif d'alimentation de composants (320) selon la revendication 7,
dans lequel, quand l'unité de lecture (330) est montée sur le porteur (10), l'unité de lecture (330) lit en outre un deuxième identifiant (14) attaché au porteur (10).

9. Dispositif d'alimentation de composants (420) qui alimente des composants électroniques (8) à un monteur de puces (2), le dispositif d'alimentation de composants (420) comprenant :
des porteurs (10), qui portent chacun au moins un composant électronique (8) et à chacun desquels est attaché un deuxième identifiant (14) ;
une pluralité de sections de réception (36), qui reçoivent chacune l'un des porteurs (10) ;
une pluralité de premiers identifiants (48), qui sont chacun respectivement assignés à une section de la pluralité de sections de réception (36) ;
une unité de lecture (430) qui est configurée pour lire les premiers identifiants (48) et les deuxièmes identifiants (14) ;
un premier mécanisme de support (442) qui supporte l'unité de lecture (430) de telle sorte que l'unité de lecture (430) est déplaçable dans une première direction ;
un deuxième mécanisme de support (442) qui supporte l'unité de lecture (430) de telle sorte que l'unité de lecture (430) peut être tournée dans une deuxième direction ; et
un mécanisme de verrouillage (444) qui permet/prévient le déplacement de l'unité de lecture dans la première direction provoqué par le premier mécanisme de support (442),
dans lequel, quand l'unité de lecture (430) est pivotée par le deuxième mécanisme de support (442) d'une position dans laquelle l'unité de lecture (430) est configurée pour lire le deuxième identifiant (14) d'un porteur (10) placé dans une section de réception (36), dans la deuxième direction, l'unité de lecture (430) atteint une position dans laquelle l'unité de lecture (430) est configurée pour lire le premier identifiant (48) assigné à la section de réception (36).

10. Dispositif d'alimentation de composants (420) selon la revendication 9,
dans lequel les sections de la pluralité de sections de réception (36) sont agencées en direction verticale et dans lequel les identifiants de la pluralité de premiers identifiants (48) sont agencés en direction verticale, et/ou dans lequel chaque identifiant de la pluralité de premiers identifiants (48) est positionné à la même hauteur qu'une section de réception correspondante (36).

11. Dispositif d'alimentation de composants (620) qui alimente des composants électroniques (8) à un monteur de puces (2), le dispositif d'alimentation de composants (620) comprenant :
des porteurs (10), qui portent chacun au moins un composant électronique (8) ;
une pluralité de sections de réception (36), qui reçoivent chacune l'un des porteurs (10) ;
une pluralité de gabarits de grille (640), qui sont chacun respectivement fixés à une section de la pluralité de sections de réception (36), et
une pluralité de gabarits de clé (650), qui peuvent être montés chacun sélectivement sur l'un des porteurs (10),
dans lequel les gabarits de la pluralité de gabarits de grille (640) ont des formes qui diffèrent entre elles, et
chaque gabarit de la pluralité de gabarits de grille (640) présente une forme qui permet à la section de réception (36) de recevoir un porteur (10) sur lequel est monté un gabarit de clé correspondant (650) parmi la pluralité de gabarits (650), et ne permet pas à la section de réception (36) de recevoir les porteurs (10) sur lesquels sont montés les autres gabarits de clé (650).
